Europäisches Patentamt

European Patent Office

Office européen des brevets

(11) Publication number: **0 224 922**
**A2**

## (12) EUROPEAN PATENT APPLICATION

(21) Application number: **86116848.2**

(51) Int. Cl.⁴: **H05K 1/02**

(22) Date of filing: **04.12.86**

(30) Priority: **04.12.85 SE 8505725**

(43) Date of publication of application:
**10.06.87 Bulletin 87/24**

(84) Designated Contracting States:
**DE FR GB NL SE**

(71) Applicant: **Perstorp AB**
**Box 5000**
**S-284 00 Perstorp(SE)**

(72) Inventor: **Hertzberg, Hans Tommy**
**Fasanvägen 7 C**
**S-284 00 Perstorp(SE)**

(74) Representative: **Hansen, Bernd, Dr.rer.nat. et al**
**Hoffmann, Eitle & Partner Patentanwälte**
**Arabellastrasse 4 Postfach 81 04 20**
**D-8000 München 81(DE)**

(54) Invar foil.

(57) Invar foil, mainly intended for the production of printed circuit boards. Said foil comprises an electroplated invar layer.

EP 0 224 922 A2

## Invar foil

The present invention relates to an invar foil, mainly intended for the production of printed circuit boards and the use of such a foil.

Printed circuit boards are used to a large extent in the electronics industry. Printed circuit boards are usually produced by placing a copper foil on one or both sides of one or more layers of a fibre material (so-called prepreg) impregnated with partially cured plastic.

Then pressing at a high pressure and an elevated temperature is carried out. Hereby a final curing of the plastic, which is binding the fibre material to a sheet (an insulating carrier), is obtained. The copper foil is firmly bonded to said sheet.

The most common insulating bases are paper-reinforced phenol formaldehyde plastic laminates, which are used for comparatively simple circuits, and glass cloth reinforced epoxy resin laminates, which are used where the technical requirements are higher.

The copper foil has usually a thickness of 15-35 $\mu$, but also foils with a thickness of e.g. 5 $\mu$ can be used if the temporary carrier process in accordance with the U.S. patent Re 29,820 is used. Also copper foils in thicknesses of more than 35 $\mu$ are used in some cases.

After the pressing a copy of the desired wiring pattern is transferred to the copper layer for instance by printing or by a photo-chemical method. The applied copy, the so-called etch resist, acts as a protection during a subsequent elimination by etching of superfluous copper. Thereafter, the electronic components are mounted to the laminate with the circuit thus obtained, the so-called printed circuit board. The copper conductors of the circuit constitute the required electrical connections and the laminate provides the mechanical support. This technique provides good possibilities of space and weight saving build-up of the electronic unit. The method affords high reliability and rational production. Also so-called multilayer boards are very common nowadays.

Said multilayer boards consist of a number of copper layers with wiring patterns which are separated by insulating layers and laminated as described above.

For a long period of time, the trend in the electronics field has been towards increased complexity with more and more electronic components per surface area. In the last few years the subject of the discussions has to a large extent related to the concept surface mounting, i.e. printed circuit boards having the components mounted directly on the copper surface of the board by means of soldering. This eliminates the drilling of holes for the component legs, which was done previously, and is consequently very space-saving. Surface mounting is mostly used on multilayer boards and it makes it possible to increase the packaging density by 200-300 %.

However, an increased packaging density results in an increased heat release per surface area. This in turn gives thermal problems, especially as regards surface mounted boards.

A ceramic chip carrier (C.C.C.) has a thermal coefficient of expansion (TCE) of about 7 ppm/°C. The corresponding value for copper is 16 and for glass cloth reinforced epoxy resin laminate 12-16.

Heating of the surface mounted components in the form of such ceramic chips results in a shearing in the soldered joints since the carrier expands to a larger extent than the C.C.C. This shearing can result in cracking of the soldered joint or in complete loosening of the component. In either case, the life of the board is drastically reduced.

Different methods are used to overcome this problem. One method is to exchange the ceramic of the components for other materials having a TCE which is adapted in a better way to the TCE of the substrate. Another method is to reduce the thermal coefficient of thermal expansion of the carrier in various ways. As regards the first method, there are currently no commercially useful materials except for plastic chip carriers. The problems with said plastic chip carriers are solderability and difficulties to obtain completely tight carriers. As regards the second method, trials have been made to exchange the glass cloth reinforcement for other materials having a lower TCE, e.g. carbon fibre or quartz. However, these materials cause problems, such as water absorption, delamination, drilling difficulties etc. `

Rolled copper-invar foils have also been used recently in an effort to decrease the above mentioned problem with thermal expansion of printed circuit boards. The problems have, however, been solved only to a certain degree by said method. Such rolled foils namely have several disadvantages. For instance, they cannot be produced in thicknesses less than about 100 $\mu$. This often means that the printed circuit boards from a technical view point get heavier and thicker than necessary. Thereby, the design of the printed circuit board cannot be varied as desired.

According to the present invention it has quite surprisingly been possible to solve the above-mentioned problem with different coefficients of thermal expansion of the surface mounted ceramic components and the substrate (the printed circuit board).

Thus, an invar foil mainly intended for the production of printed circuit boards has been brought about. Said foil comprises an electroplated invar layer.

Invar is a metal alloy consisting of about 36 % nickel and about 64 % iron.

The invar foil is intended to be used as a ground plane, a power plane and/or a layer reducing the thermal expansion of a printed circuit board, preferably a multilayer board having a TCE of 5-9, preferably 6-8 ppm/°C.

The electro-plated invar foil can be produced in various ways according to the invention. The invar can be electro-plated on a carrier, e.g. a copper foil or on a steel drum. Subsequently, copper can possibly be electro-plated to the desired thickness, on one or both sides of the invar foil obtained. The methods provide great possibilities to vary the thickness of the invar foil and the possible copper layers.

Thus, according to the invention it is possible to produce printed circuit boards, especially multilayer boards, having the desirable low (6-8 ppm/°C) coefficient of thermal expansion by varying the number of invar layers, copper/invar layers or copper/invar/copper layers with a suitable thickness in proportion to the number of prepreg layers with a suitable thickness, which are used for the manufacture of the printed circuit boards. Since the printed circuit board obtains the same coefficient of thermal expansion as the ceramic chip carriers being used as surface mounted components, the thermal problem described above is avoided.

According to the invention, the invar foil can be produced in a width adapted to common laminate presses. Usually, the foil has a width of 1 meter and a thickness of 1-300 $\mu$, preferably 1-100 $\mu$ and most preferably 10-75 $\mu$. Especially desirable is 20-50 $\mu$. Since the foil is produced continuously, it can be obtained in the desired length in the form of rolls.

As a rule, the plating of alloys is always more difficult than the plating of pure metals. Electro-plating of invar requires very carefully controlled conditions of production. Moreover, since the interesting physical properties of the invar depend on the composition, the degree of purity of the baths is of decisive significance.

Said problems constitute some of the reasons for the fact that there is no electro-plated invar foil previously on the market, in spite of the great need for such a foil for the production of printed circuit boards with a lower coefficient of thermal expansion than that of boards previously known.

The possible copper layers on the invar foil can be electro-plated as mentioned above. However, it is also possible to use a chemical plating only or to plate a thin chemical copper layer on the invar foil first and then electro-plate a copper layer on the chemical copper. The copper layer has usually a thickness of 1-200 $\mu$, preferably 1-35 $\mu$. But in certain cases it can have a thickness of only 1-17 $\mu$, e.g. 3-15 $\mu$.

The invar layer and/or the possible copper layer or layers can be provided with an adhesion promoting layer intended to give a good adhesion between the electrically conducting layers and the insulating carrier. Said adhesion promoting layer can be obtained by a so-called treatment which can be provided by an electro-chemical method. The result of the treatment is a rough surface which gives a good adhesion.

Alternatively, a rolled invar foil is used, onto which an electro-plated copper layer has been applied on at least one side. The disadvantage with a rolled invar foil is, however, that it cannot be manufactured in thin qualities as mentioned above. Said foil is also limited in respect of widths.

Furthermore, rolling is an expensive production method and consequently only a limited number of thicknesses can be considered for production. This means that there are limited possibilities to produce printed circuit boards with the previously mentioned low coefficient of thermal expansion when using a rolled invar foil.

The invention will be illustrated more in detail below with reference to the examples, of which Examples 1, 2 and 4 show a production of an electro-plated invar foil provided with electro-plated copper layers on both sides. Example 3 relates to the production of an electro-plated invar foil with an adhesion promoting layer but without copper layers. Finally, Example 5 illustrates how to apply electro-plated copper layers on both sides of a rolled invar foil.

Example I

A 40 $\mu$ thick aluminium foil having a 5 $\mu$ thick electro-plated copper layer on one side was plated on the copper layer for 7.6 min at 40°C with an electrolyte containing:

| | |
|---|---|
| Stabilizer | 4 g/l |
| Nickel sulphamate | 500 g/l |
| Ferrous sulphate | 170 g/l |
| Sodium acetate | 30 g/l |
| Sodium lauryl sulphate | 1 g/l |
| Naphtalene trisulphonic acid | 2 g/l |
| | |
| Current density | 50 A/dm² |

The stabilizer consisted of a mixture of sodium tartrate, ascorbic acid and a sodium salt of ortho-dihydroxo benzene and disulphonic acid. pH was adjusted to 3.5 by means of acetic acid.

The thickness of the iron/nickel alloy obtained was gauged to 50 $\mu$ and the alloy consisted of 36 % nickel and 64 % iron (invar).

Thereafter, a copper strike was carried out in a water bath containing:

$Cu_2P_2O_7 \cdot 4H_2O$    50 g/l
$K_4P_2O_7$    240 g/l
Time 85 s.
Cathode current density 2 A/dm²
Temperature 50°C
pH 8.6.

After the copper strike the foil was plated electrolytically with copper for 1 min. in a water bath containing:
$CuSO_4$    125 g/l
$H_2SO_4$    50 g/l
Current density 20 A/dm².

Thereafter, the foil was nodulized for 20 s. in a water bath containing:
$CuSO_4$    10 g/l
$H_2SO_4$    70 g/l
Current density 11 A/dm².

A subsequent final plating in the last-mentioned, more concentrated copper sulphate electrolyte for 20 s. at 25 A/dm² resulted in a 50 $\mu$ thick invar foil with 5 $\mu$ copper on each side. The aluminium foil was etched off in a water bath containing:
Sodium hydroxide    50 g/l
Sodium gluconate    1 g/l

The product was then nodulized or black-oxidized on the even, exposed copper surface. At the nodulizing alternative, the copper surface was then finally plated as disclosed above.

## Example 2

An invar alloy was plated electrolytically on a drum (of stainless steel) in a water bath containing:
Nickel sulphamate    500 g/l
Ferrous sulphate    170 g/l
Sodium acetate    30 g/l
Sodium lauryl sulphate    1 g/l
Naphthalene trisulphonic acid    2 g/l
Stabilizer as in Example 1    4 g/l
pH was adjusted to 3.5 by means of acetic acid. The dwell time was 9.5 min. and the current density 50 A/dm₂ The formed invar foil having a thickness of 75 $\mu$ was peeled off.

Thereafter a copper strike was carried out in a water bath containing:
$Cu_2P_2O_7 \cdot 4H_2O$    50 g/l
$K_4P_2O_7$    240 g/l
Time 85 s.
Cathode current density 2 A/dm²
Temperature 50°C
pH 8.6.

The foil was then plated for 1 min. in a water bath containing:
$CuSO_4$    125 g/l
$H_2SO_4$    60 g/l
Current density 20 A/dm².

Thereafter, the plating was carried on for 20 s. in a more diluted electrolyte:
$CuSO_4$    10 g/l
$H_2SO_4$    70 g/l
Current density 11 A/dm².

A repetition of the first copper sulphate plating for 20 s. resulted in an end product consiting of 10 $\mu$ copper/75 $\mu$ invar/10 $\mu$ copper.

## Example 3

An invar foil was electro-plated on a drum in the same manner as described in Example 2.

The invar foil produced in this way with a thickness of 75 $\mu$ was thereafter plated in a similar invar bath with less stirring, less current density, 10 A/dm², and a more diluted solution.

The surface modification of the invar foil thereby obtained resulted, after pressing the foil towards prepregs of glass cloth impregnated with epoxy resin, in a peel strength between the invar foil and the glass cloth reinforced epoxy laminate of 2.2 N/mm.

## Example 4

The process described in Example 1 was repeated with the difference that a 17.5 $\mu$ thick carrierless copper foil was used for the invar plating instead of the aluminium foil with 5 $\mu$ copper. Furthermore, the invar plating time was 15.2 min. instead of 7.6 min. according to Example 1.

Also, the dwell time in the first copper sulphate bath was 2 min. instead of 1 min. The subsequent nodulization process step as well as the final copper plating step corresponded to those of Example 1. The end product was a 150 $\mu$ thick invar foil covered on both sides with 17.5 $\mu$ thick electroplated copper layers.

Example 5

A rolled invar foil with a thickness of 100 $\mu$ was degreased for 32 s. in a water bath containing:

NaOH      30 g/l
NaCO$_3$      46 g/l
Rochelle salt      46 g/l
Temperature 40°C.

Thereafter, the invar foil was rinsed in water for 20 s.

The foil was then subject to a rough chemical etching in a water bath containing:

H$_2$SO$_4$      300 ml/l

for 25 s. and at a temperature of 25°C, whereby the last residues of rolling oil on the invar foil were removed at the same time.

The rough etching was interrupted by means of a conducting roller.

Thereafter, a copper strike was carried out in a water bath containing:

Cu$_2$P$_2$O$_7 \bullet$ 4H$_2$O      50 g/l
K$_4$P$_2$O$_7$      240 g/l
Time 85 s.
Cathode current density 2 A/dm$^2$
Temperature 50°C
pH 8.6.

The foil was then copper-plated in the same manner as according to Example 2. The end product obtained was a rolled invar foil with a thickness of 100 $\mu$ covered on both sides with a 10 $\mu$ thick electro-plated copper layer.

The invention is not limited to the embodiments shown, since these can be modified in different ways within the scope of the invention.

**Claims**

1. Invar foil mainly intended for the production of printed circuit boards, which comprises an electro-plated invar layer.

2. Foil according to claim 1, wherein the invar layer is provided on at least one side with a chemical and/or an electro-plated copper layer.

3. Foil according to claim 1 or 2, wherein the invar layer has a thickness of 1-100 $\mu$, preferably 10-75 $\mu$.

4. Foil according to claim 2 or 3, wherein the copper layer has a thickness of 1-200 $\mu$.

5. Foil according to any one of claims 1-4, wherein the invar layer is provided on both sides with an electro-plated copper layer.

6. Foil according to any one of claims 1-5, wherein the invar layer and/or the copper layer or layers are provided with an adhesion promoting layer.

7. Use of an invar foil comprising an electro-plated invar layer optionally provided with a copper layer on at least one side, as a ground plane, a power plane and/or as a layer reducing the thermal expansion of a printed circuit board, preferably a multilayer board with a coefficient of thermal expansion of 5-9, preferably 6-8 ppm/°C.